# EUROPEAN PATENT SPECIFICATION

(11) **EP 2 706 091 B1**
(45) Date of publication and mention of the grant of the patent: **28.06.2017**
(21) Application number: 13160116.3
(22) Date of filing: 20.03.2013
(51) Int. Cl.: C08K 5/5313, C08G 59/42, C08L 63/00

(54) **Epoxy resin composition, and prepreg and copper clad laminate made therefrom**
Epoxidharzzusammensetzung sowie Prepreg und kupferkaschiertes Laminat daraus
Composition de résine époxy, préimprégné et stratifié revêtu de cuivre fabriqué à partir de ceux-ci

(30) Priority: 07.09.2012 CN 201210330407
(43) Date of publication of application: 12.03.2014
(73) Proprietor: Shengyi Technology Co., Ltd., 523000 Dongguan City Guangdong (CN)
(72) Inventor: Zeng, Xianping, 523000 Dongguan City (CN); Ren, Nana, 523000 Dongguan City (CN); Zhou, Biao, 523000 Dongguan City (CN)
(74) Representative: Ricker, Mathias

(56) References cited:
- DATABASE WPI Week 201253 Thomson Scientific, London, GB; AN 2012-F88050 XP002715432, & CN 102 443 138 A (GUANGDONG SHENGYI SCI TECH CO) 9 May 2012 (2012-05-09)
- DATABASE WPI Week 200258 Thomson Scientific, London, GB; AN 2002-540890 XP002715433, & JP 2002 012650 A (DAINIPPON INK & CHEM INC) 15 January 2002 (2002-01-15)
- DATABASE WPI Week 200976 Thomson Scientific, London, GB; AN 2009-Q20464 XP002715434, & JP 2009 242559 A (DAINIPPON INK&CHEM INC) 22 October 2009 (2009-10-22)

## Description

### FIELD OF THE INVENTION

The present invention relates to an epoxy resin composition, particularly relates to an epoxy resin composition, and a prepreg and a copper clad laminate made therefrom.

### BACKGROUND OF THE INVENTION

With the development of high speed, multifunctional information processing of electronic products, the applied frequency becomes higher and higher, and an applied frequency of 3-6 GHz will become mainstream, so, besides higher requirement to the heat resistance of a laminate material, the dielectric constant and dielectric loss value thereof are required to be lower and lower. Existing conventional FR-4 materials are hard to meet the development requirement of high frequency, high speed electronic products, and at the same time, substrate materials will not only play the traditional role as a mechanical support, but, together with electronic components, will be an important way for producers and designers of PCBs and terminals to improve the product performance. High DK will make the signal transmission rate slow, and high Df will make part of the signal be converted into heat energy that will be wasted in the substrate materials, so, decreasing DK/Df has become a focus for the field of substrates. Conventional FR-4 materials generally adopt dicyandiamide as the curing agent that has good processbility for the tertiary amine thereof, but because the C-N bond thereof is comparatively weak to be easily cracked at high temperature, the thermal decomposition temperature of the cured products is comparatively low to be hard to meet the heat resistance requirement of lead-free technology. In such a background, with lead-free technology being widely carried out since the year 2006, phenolic resin are adopted as the curing agent for epoxy resin. Phenolic resin has high density of benzene ring heat resistance structure, so the heat resistance of the resin system of cured phenolic resin and epoxy resin has excellent heat resistance, but, the trend that the dielectric properties of the cured products get deteriorated appears at the same time.

Japanese patent publication No. 2002-012650, and Japanese patent publication No. 2003-082063 disclose a series of active ester curing agents containing benzene ring, naphthalene ring or biphenyl structure as the curing agent for epoxy resin, such as IAAN, IABN, TriABN, and TAAN, comparing with conventional phenolic resin, which can obviously decrease the dielectric constant and dielectric loss value of the cured products.

Japanese patent publication No. 2003-252958 discloses that the dielectric constant and dielectric loss value of the cured products can be decreased by adopting biphenyl type epoxy resin and active ester as the curing agent, but, because the adopted epoxy resin is bifunctional and the crosslinking density of the active ester is low, the cured products have comparatively low heat resistance and glass transition temperature.

Japanese patent publication No. 2004-155990 discloses a multifunctional active ester curing agent obtained by aromatic carboxylic acid reacting with aromatic phenol, and cured products with comparatively high heat resistance, good dielectric constant and good dielectric loss value can be obtained by using the multifunctional active ester curing agent to cure novolac type epoxy resin.

Japanese patent publication No. 2009-235165 discloses a new multifunctional active ester curing agent, which can obtain cured products with comparatively high glass transition temperature, comparatively low dielectric constant and dielectric loss value by curing an epoxy resin containing aliphatic structure.

Japanese patent publication No. 2009-040919 discloses a thermosetting resin composition with stable dielectric constant and excellent adherence to conducting layer, which mainly comprises an epoxy resin, an active ester hardener, a hardening accelerator, and an organic solvent. Wherein, the obtained cured products have good adherence to copper foils, dielectric constant and dielectric loss value; the usage amount of the epoxy resin and active ester was studied, but the relationship of the structure and property of the epoxy resin and active ester was not studied.

In addition, Japanese patent publication No. 2009-242559, Japanese patent publication No. 2009-242560, Japanese patent publication No. 2010-077344, and Japanese patent publication No. 2010-077343 respectively disclose that cured products with low hydroscopic property, low dielectric constant and dielectric loss tangent can be obtained from alkylated phenol novolac type epoxy resin, alkylated naphthol novolac type epoxy resin, and biphenyl type novolac epoxy resin by using an active ester as the curing agent.

The above existing patent technologies all disclose that active esters are used as the curing agent for epoxy resins to improve moisture resistance, decrease hydroscopic property, and decrease dielectric constant and dielectric loss value of the cured products, but the disadvantages are that it is hard to achieve good equilibrium between heat resistance and dielectric properties, which is achieved to make that the cured products could simultaneously have high glass transition temperature and low dielectric loss tangent, have comparatively stable dielectric properties under frequency variation, and have lower hydroscopic property. Meanwhile, how to achieve halogen-free flame retardance of the cured products is not studied.

### SUMMARY OF THE INVENTION

An object of the present invention is to provide an epoxy resin composition, which can provide good dielectric properties, humidity resistance and heat resistance required by a copper clad laminate, and achieve halogen-free flame retardance.

Another object of the present invention is to provide a prepreg and a copper clad laminate made from the above mentioned epoxy resin composition, which have good dielectric properties, humidity resistance and heat resistance, also have high glass transition temperature and comparatively low hydroscopic property, and can achieve halogen-free flame retardance.

To achieve the above objects, the present invention provides an epoxy resin composition, which comprises:
(A) epoxy resin containing two or more than two epoxy groups, (B) active ester curing agent, and (C) phosphinic salt compound;
   wherein the structural formula of component (A) is: 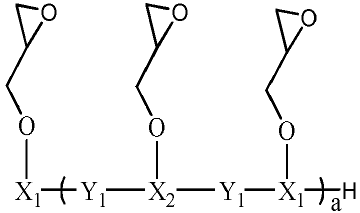 wherein X₁ and X₂ are identical or different and represent 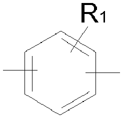 or 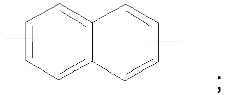 Y₁ represents -CH₂- , 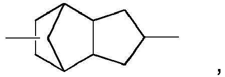 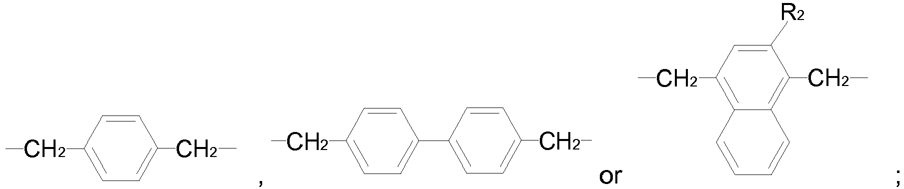 wherein R₁ represents hydrogen or an alkyl with the number of carbon atoms being 1-10; R₂ represents hydrogen or an alkyl with the number of carbon atoms being 1-10; and a represents an integer of 1-30;
   wherein component (B) is obtained from the reaction of a phenol compound containing aliphatic hydrocarbon structure as connection structure, together with bifunctional carboxylic acid aromatic compound or acid halide and a monohydroxy compound; and
   wherein component (C) is prepared by metal ion reacting with a phosphinic radical via substitution reaction and the structural formula of the phosphinic salt compound is: 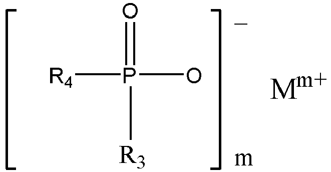 wherein m represents 2 or 3; R₃ and R₄ represent alkyl with the number of carbon atoms being 1-6 or aryl; M represents a metal atom selected from calcium, magnesium, aluminum, arsenic, zinc, and iron.

Taking the usage amount of the component (A) epoxy resin containing two or over two epoxy groups as 100 parts by weight, the usage amount of the component (B) active ester curing agent is calculated according to the equivalent ratio of epoxy equivalent weight to active ester equivalent weight, and the equivalent ratio is 0.85-1.2.

Taking the total amount of the component (A), the component (B) and the component (C) as 100 parts by weight, the usage amount of the component (C) phosphate salt compound is 5-20 parts by weight.

The usage amount of the bifunctional carboxylic acid aromatic compound or acid halide is 1 mol, the usage amount of the phenol compound containing aliphatic hydrocarbon structure as connection structure is 0.05-0.75 mol, and the usage amount of the monohydroxy compound is 0.25-0.95 mol.

The structural formula of the component (B) active ester curing agent is shown as follows: 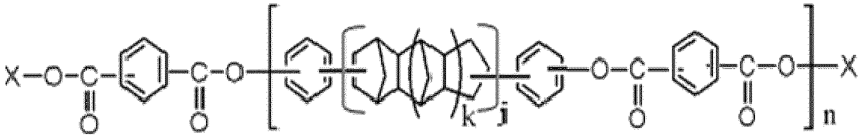 wherein X represents a benzene ring or naphthalene ring, j represents 0 or 1, k represents 0 or 1, and n ranges from 0.25 to 2.5.

The epoxy resin composition of the present invention also comprises curing accelerator, and the curing accelerator is one or a mixture of more selected from the group consisting of imidazole compounds, derivatives of imidazole compounds, piperidine compounds, Lewis acids, and triphenyl phosphine.

The epoxy resin composition of the present invention also comprises filler, which is organic filler or inorganic filler; taking the total amount of the component (A), the component (B) and the component (C) as 100 parts by weight, the usage amount of the filler is 5-500 parts by weight.

The inorganic filler is one or more selected from the group consisting of natural silica, fused silica, spherical silica, hollow silica, glass powder, aluminum nitride, boron nitride, silicon carbide, aluminum hydroxide, titanium dioxide, strontium titanate, barium titanate, alumina, barium sulfate, talcum powder, calcium silicate, calcium carbonate, and mica; the organic filler is one or more selected from polytetrafluoroethylene powder, polyphenylene sulfide powder, and poly(ether sulfones) powder.

Meanwhile, the present invention provides a prepreg made from the above mentioned epoxy resin composition, which comprises a reinforcing material, and the epoxy resin composition that adheres to the reinforcing material after the reinforcing material is dipped in the epoxy resin composition and then is dried.

In addition, the present invention also provides a copper clad laminate made from the above mentioned prepreg, which comprises a plurality of laminated prepregs and copper foil cladded to one side or two sides of the laminated prepregs.

The advantages of the present invention: (1) the epoxy resin composition of the present invention adopts epoxy resin with specific molecular structure, which has a comparatively high functionality, so the cured products have low hydroscopic property; (2) the epoxy resin composition of the present invention adopts active ester as the curing agent to make full use of the advantages that polar groups will not be produced when the active ester reacts with the epoxy resin, thereby having excellent dielectric properties and good resistance to humidity and heat, and adopts phosphorus-containing flame retardant with specific structure to achieve halogen-free flame retardance without sacrificing heat resistance, low hydroscopic property, and excellent dielectric properties of the original cured products, of which the flame retardance can reach the level of UL94 V-0; (3) the prepreg and copper clad laminate made from the above mentioned epoxy resin composition of the present invention have excellent dielectric properties and good resistance to humidity and heat, of which the flame retardance can reach the level of UL94 V-0.

### DESCRIPTION OF THE PREFERRED EMBODIMENT

The epoxy resin composition of the present invention comprises:
(A) epoxy resin containing two or more than two epoxy groups, (B) active ester curing agent, and (C) phosphinic salt compound;
   wherein the structural formula of the component (A) epoxy resin containing two or more than two epoxy groups is: 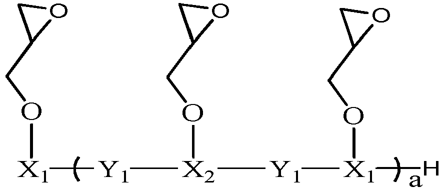 wherein X₁ and X₂ can be identical or different, which represent 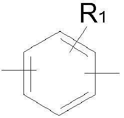 or 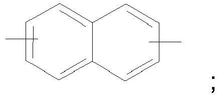 Y₁ represents -CH₂-, 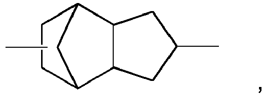 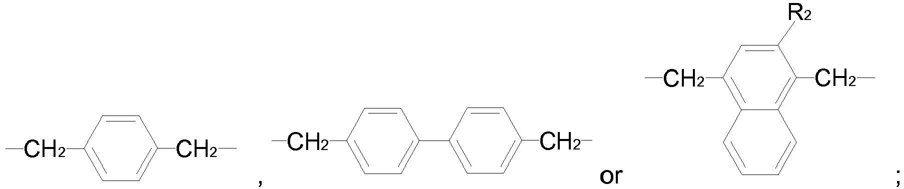 wherein R₁ represents hydrogen atom or alkyl with the number of carbon atoms being 1-10; R₂ represents hydrogen atom or alkyl with the number of carbon atoms being 1-10; and a represents an integer of 1-30.

The preferred structural formula of the component (A) epoxy resin containing two or more than two epoxy groups is shown as follows: 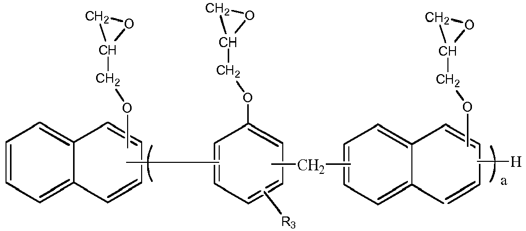 wherein a represents an integer of 1-10, R₃ represents hydrogen atom or alkyl with the number of carbon atoms being 1-5.

More specifically, the structure can be as shown in the following structural formulas: 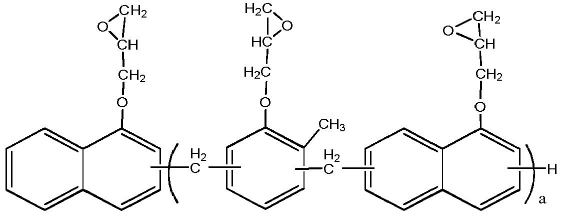 wherein a represents an integer of 1-10; and 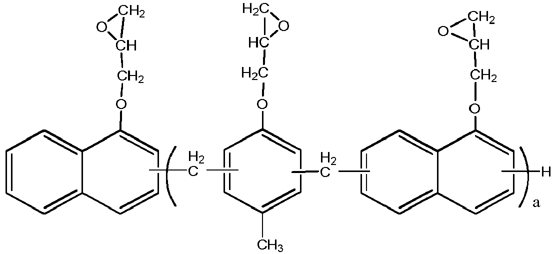 wherein a represents an integer of 1-10.

The preferred structural formula of the component (A) epoxy resin containing two or more than two epoxy groups can also be shown as follows: 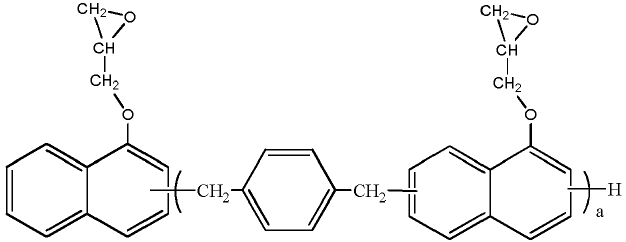 wherein a represents an integer of 1-10; 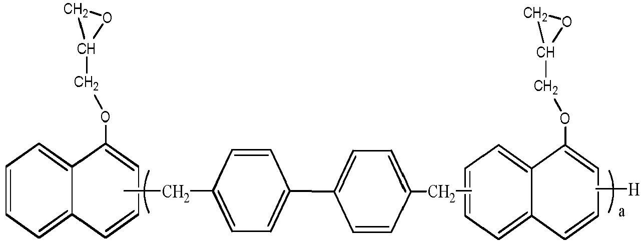 wherein a represents an integer of 1-10; 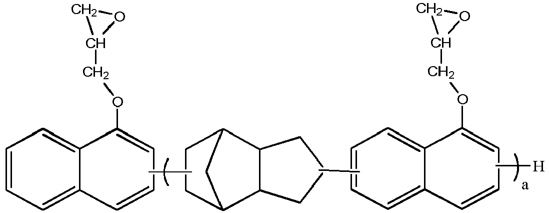 wherein a represents an integer of 1-10; 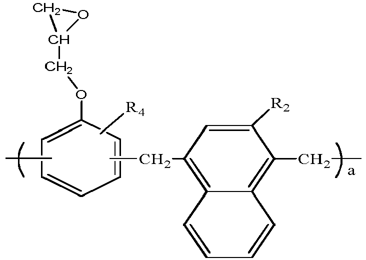 wherein a represents an integer of 1-10; R₄ represents hydrogen atom or alkyl with the number of carbon atoms being 1-5, and 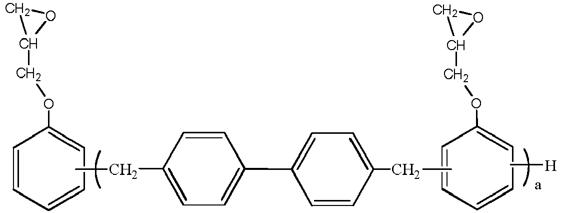 wherein a represents an integer of 1-10.

In the epoxy resin composition of the present invention, the component (B) active ester curing agent is obtained from the reaction of a phenol compound containing aliphatic hydrocarbon structure as connection structure, together with bifunctional carboxylic acid aromatic compound or acid halide, and a monohydroxy compound. The active ester is mainly used to cure the epoxy resin, and because no secondary hydroxy is produced after the active ester and the epoxy resin are cured, the cured products substantially comprise no hydroxy polar groups, thereby having good dielectric properties, low hydroscopic property, and good resistance to humidity and heat.

The usage amount of the bifunctional carboxylic acid aromatic compound or acid halide is 1 mol, the usage amount of the phenol compound containing aliphatic hydrocarbon structure as connection structure is 0.05-0.75 mol, and the usage amount of the monohydroxy compound is 0.25-0.95 mol. The structure of the bifunctional hydroxy carboxyl can be defined as follows: 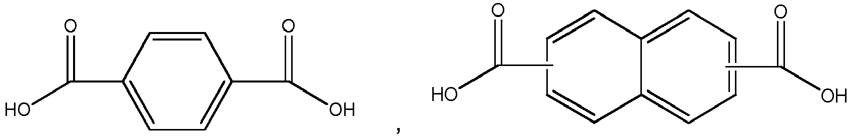 or 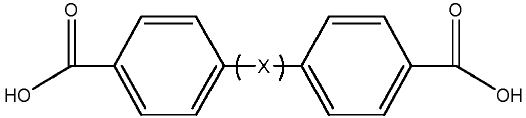 wherein X represents alkylene with the number of carbon atoms being 1-5.

The structure of the phenol compound containing aliphatic hydrocarbon structure as connection structure can be defined as the follows: 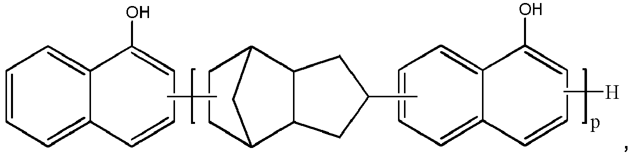 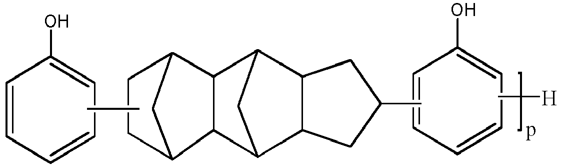 or 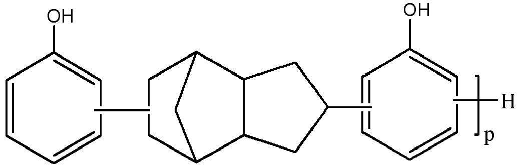 wherein p represents an integer of 1-5.

The preferred structural formula of the component (B) active ester curing agent is: 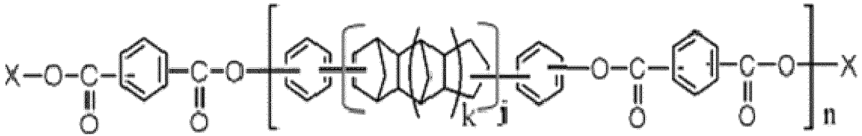 wherein X represents a benzene ring or naphthalene ring, j represents 0 or 1, k represents 0 or 1, and n ranges from 0.25 to 2.5.

Taking the usage amount of the component (A) epoxy resin containing two or more than two epoxy groups as 100 parts by weight, the usage amount of the active ester curing agent is calculated according to the equivalent ratio of epoxy equivalent weight to active ester equivalent weight, thus, the equivalent ratio is 0.85-1.2, preferred to be 0.9-1.1, and more preferred to be 0.95-1.05.

In the epoxy resin composition of the present invention, the component (C) phosphinic salt compound has the following structural formula: 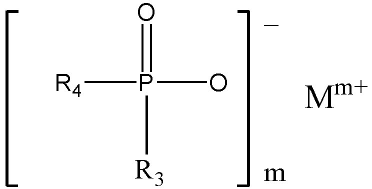 wherein m represents 2 or 3; R₃ and R₄ represent alkyl with the number of carbon atoms being 1-6 or aryl; M represents metal atom that is one selected from calcium, magnesium, aluminum, arsenic, zinc, and iron. Considering from decreasing the hydroscopic property and increasing the phosphorus content of the epoxy resin composition, M is preferred to be aluminum or sodium, but if further considering from as far as possible decreasing the effect of the addition of the flame retardant to the dielectric properties of the cured epoxy resin composition, M is more preferred to be aluminum.

More particularly, the structural formula of the phosphinic salt compound of the present invention is: 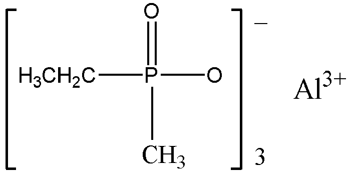 or

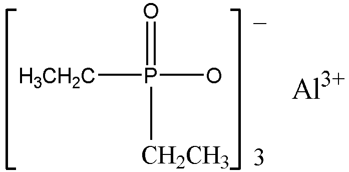

The object of the phosphinic salt compound in the present invention is for flame retardance, of which the usage amount is not particularly restrictive, so long as it can make the cured products to reach the level of UL 94 V-0. To ensure the cured products to have better overall performances, such as heat resistance and hydrolysis resistance, taking the total amount of the component (A), the component (B) and the component (C) as 100 parts by weight, the usage amount of the phosphinic salt compound is 5-20 parts by weight, and further preferred to be 8-15 parts by weight.

The epoxy resin composition of the present invention can also comprise curing accelerator. The curing accelerator is not particularly restrictive, so long as it can catalyze the reaction of epoxy group and decrease the reaction temperature of the curing system, which is preferred to be one or a mixture of more selected from the group consisting of imidazole compounds, derivatives of imidazole compounds, piperidine compounds, Lewis acids, and triphenyl phosphine. The imidazole compounds can be such as 2-methylimidazole, 2-phenylimidazole, and 2-ethyl-4-methylimidazole; the piperidine compounds can be such as 2,3-diaminopiperidine, 2,5-diaminopiperidine2,6-diaminopiperidine,2,5-diamino-3-methylpiperidine, 2-amino-4-4methylpiperidine, 2-amino-3-nitropiperidine, 2-amino-5-nitropiperidine, and 4-dimethylaminopiperidine. Taking the total amount of the component (A), the component (B) and the component (C) as 100 parts by weight, the usage amount of the curing accelerator is 0.05-1.0 parts by weight.

The epoxy resin composition of the present invention can also comprise filler, which is organic filler or inorganic filler. The filler that can be added as required is not particularly restrictive; the inorganic filler can be one or more selected from the group consisting of natural silica, fused silica, spherical silica, hollow silica, glass powder, aluminum nitride, boron nitride, silicon carbide, aluminum hydroxide, titanium dioxide, strontium titanate, barium titanate, alumina, barium sulfate, talcum powder, calcium silicate, calcium carbonate, and mica; the organic filler can be one or more selected from polytetrafluoroethylene powder, polyphenylene sulfide, and poly(ether sulfones) powder. In addition, the shape, particle diameter, etc. of the inorganic filler is not particularly restrictive. The particle diameter generally is 0.01-50 µm, preferred to be 0.01-20 µm, and more preferred to be 0.1-10 µm; the inorganic filler in such a range of particle diameter is more easily dispersed in the resin solution. In addition, taking the total amount of the component (A), the component (B) and the component (C) as 100 parts by weight, the usage amount of the filler is not particularly restrictive, which is 5-500 parts by weight, preferably 5-300 parts by weight, more preferably 5-200 parts by weight, and most preferably 15-100 parts by weight.

The prepreg made from the above mentioned epoxy resin composition comprises a reinforcing material, and the epoxy resin composition that adheres to the reinforcing material after the reinforcing material is dipped in the epoxy resin composition and then is dried. The reinforcing material can use reinforcing materials of existing technology, such as fiberglass cloth.

The copper clad laminate made from the above mentioned prepreg comprises a plurality of laminated prepregs and copper foil cladded to one side or two sides of the laminated prepregs.

Prepare the epoxy resin composition of the present invention into a solution with a certain concentration, dip the reinforcing material in the solution, and then dry the reinforcing material under a certain temperature to remove the solvent and semi-cure the epoxy resin composition, thereby obtaining the prepreg. Then, overlay a plurality of the prepregs with each other in a certain sequence, respectively clad copper foils to the two sides of the prepregs overlaid with each other, and then cure the prepregs in hot press at a curing temperature of 150-250 °C and a curing pressure of 25-60 kg/cm², thereby obtaining a copper clad laminate.

The following embodiments are merely examples to explain the present invention, and not to limit the scope of the present invention.

### Embodiment 1:

Set a vessel, add 100 parts by weight of naphthol type novolac epoxy resin NC-7300L (provided by Nippon Kayaku Co.,Ltd., EEW being 214 g/eq) into the vessel, then add 105 parts by weight of HPC-8000-65T (provided by Japanese DIC Co., Ltd., solid content being 65%) as the active ester curing agent to stir evenly, then add 30 parts by weight of phosphinic aluminum salt (provided by Clariant company, phosphorus content being 23%) as the flame retardant, then add 0.075 parts by weight of DMAP as the curing accelerator, then add methylbenzene as a solvent into the vessel, and continue to stir evenly, thereby obtaining a glue solution. Dip fiberglass cloth (type being 2116, thickness being 0.08 mm) in the above mentioned glue solution, control the fiberglass cloth to get an appropriate thickness, and then dry the fiberglass cloth by heat to remove the solvent, thereby obtaining prepregs. Overlay a plurality of the prepared prepregs with each other, respectively clad a piece of copper foil to the two sides of the prepregs overlaid with each other, and then cure the prepregs in hot press at a curing temperature of 150-250 °C, a curing pressure of 25-60 kg/cm² and a curing time of 90 minutes, thereby obtaining a copper clad laminate.

### Embodiment 2:

Set a vessel, add 100 parts by weight of naphthol type novolac epoxy resin NC-7000L (provided by Nippon Kayaku Co.,Ltd., EEW being 232 g/eq) into the vessel, then add 95 parts by weight of HPC-8000-65T (provided by Japanese DIC Co., Ltd., solid content being 65%) as the active ester curing agent to stir evenly, then add 30 parts by weight of phosphinic aluminum salt (provided by Clariant company, phosphorus content being 23%) as the flame retardant, then add 0.075 parts by weight of DMAP as the curing accelerator, then add methylbenzene as a solvent into the vessel, and continue to stir evenly, thereby obtaining a glue solution. Dip fiberglass cloth (type being 2116, thickness being 0.08 mm) in the above mentioned glue solution, control the fiberglass cloth to get an appropriate thickness, and then dry the fiberglass cloth by heat to remove the solvent, thereby obtaining prepregs. Overlay a plurality of the prepared prepregs with each other, respectively clad a piece of copper foil to the two sides of the prepregs overlaid with each other, and then cure the prepregs in hot press at a curing temperature of 150-250 °C, a curing pressure of 25-60 kg/cm² and a curing time of 90 minutes, thereby obtaining a copper clad laminate.

### Embodiment 3:

Set a vessel, add 100 parts by weight of naphthol type novolac epoxy resin HP-5000 (provided by Japanese DIC Co., Ltd., EEW being 250 g/eq) into the vessel, then add 90 parts by weight of HPC-8000-65T (provided by Japanese DIC Co., Ltd., solid content being 65%) as the active ester curing agent to stir evenly, then add 35 parts by weight of phosphinic aluminum salt (provided by Clariant company, phosphorus content being 23%) as the flame retardant, then add 0.075 parts by weight of DMAP as the curing accelerator, then add methylbenzene as a solvent into the vessel, and continue to stir evenly, thereby obtaining a glue solution. Dip fiberglass cloth (type being 2116, thickness being 0.08 mm) in the above mentioned glue solution, control the fiberglass cloth to get an appropriate thickness, and then dry the fiberglass cloth by heat to remove the solvent, thereby obtaining prepregs. Overlay a plurality of the prepared prepregs with each other, respectively clad a piece of copper foil to the two sides of the prepregs overlaid with each other, and then cure the prepregs in hot press at a curing temperature of 150-250 °C, a curing pressure of 25-60 kg/cm² and a curing time of 90 minutes, thereby obtaining a copper clad laminate.

### Embodiment 4:

Set a vessel, add 100 parts by weight of dicyclopentadiene type novolac epoxy resin HP-7200H (provided by Japanese DIC Co., Ltd., EEW being 278 g/eq) into the vessel, then add 79.6 parts by weight of HPC-8000-65T (provided by Japanese DIC Co., Ltd., solid content being 65%) as the active ester curing agent to stir evenly, then add 35 parts by weight of phosphinic aluminum salt (provided by Clariant company, phosphorus content being 23%) as the flame retardant, then add 0.075 parts by weight of DMAP as the curing accelerator, then add methylbenzene as a solvent into the vessel, and continue to stir evenly, thereby obtaining a glue solution. Dip fiberglass cloth (type being 2116, thickness being 0.08 mm) in the above mentioned glue solution, control the fiberglass cloth to get an appropriate thickness, and then dry the fiberglass cloth by heat to remove the solvent, thereby obtaining prepregs. Overlay a plurality of the prepared prepregs with each other, respectively clad a piece of copper foil to the two sides of the prepregs overlaid with each other, and then cure the prepregs in hot press at a curing temperature of 150-250 °C, a curing pressure of 25-60 kg/cm² and a curing time of 90 minutes, thereby obtaining a copper clad laminate.

### Embodiment 5:

Set a vessel, add 100 parts by weight of aralkyl phenyl type novolac epoxy resin NC-2000L (provided by Nippon Kayaku Co.,Ltd., EEW being 238 g/eq) into the vessel, then add 93.7 parts by weight of HPC-8000-65T (provided by Japanese DIC Co., Ltd., solid content being 65%) as the active ester curing agent to stir evenly, then add 35 parts by weight of phosphinic aluminum salt (provided by Clariant company, phosphorus content being 23%) as the flame retardant, then add 0.075 parts by weight of DMAP as the curing accelerator, then add methylbenzene as a solvent into the vessel, and continue to stir evenly, thereby obtaining a glue solution. Dip fiberglass cloth (type being 2116, thickness being 0.08 mm) in the above mentioned glue solution, control the fiberglass cloth to get an appropriate thickness, and then dry the fiberglass cloth by heat to remove the solvent, thereby obtaining prepregs. Overlay a plurality of the prepared prepregs with each other, respectively clad a piece of copper foil to the two sides of the prepregs overlaid with each other, and then cure the prepregs in hot press at a curing temperature of 150-250 °C, a curing pressure of 25-60 kg/cm² and a curing time of 90 minutes, thereby obtaining a copper clad laminate.

### Embodiment 6:

Set a vessel, add 100 parts by weight of biphenyl type novolac epoxy resin NC-3000H (provided by Nippon Kayaku Co.,Ltd., EEW being 288 g/eq) into the vessel, then add 77.5 parts by weight of HPC-8000-65T (provided by Japanese DIC Co., Ltd., solid content being 65%) as the active ester curing agent to stir evenly, then add 30 parts by weight of phosphinic aluminum salt (provided by Clariant company, phosphorus content being 23%) as the flame retardant, then add 0.075 parts by weight of DMAP as the curing accelerator, then add methylbenzene as a solvent into the vessel, and continue to stir evenly, thereby obtaining a glue solution. Dip fiberglass cloth (type being 2116, thickness being 0.08 mm) in the above mentioned glue solution, control the fiberglass cloth to get an appropriate thickness, and then dry the fiberglass cloth by heat to remove the solvent, thereby obtaining prepregs. Overlay a plurality of the prepared prepregs with each other, respectively clad a piece of copper foil to the two sides of the prepregs overlaid with each other, and then cure the prepregs in hot press at a curing temperature of 150-250 °C, a curing pressure of 25-60 kg/cm² and a curing time of 90 minutes, thereby obtaining a copper clad laminate.

### Embodiment 7:

Set a vessel, add 100 parts by weight of naphthol type novolac epoxy resin HP-6000 (provided by Japanese DIC Co., Ltd., EEW being 250 g/eq) into the vessel, then add 90 parts by weight of HPC-8000-65T (provided by Japanese DIC Co., Ltd., solid content being 65%) as the active ester curing agent to stir evenly, then add 35 parts by weight of phosphinic aluminum salt (provided by Clariant company, phosphorus content being 23%) as the flame retardant, then add 0.075 parts by weight of DMAP as the curing accelerator, then add methylbenzene as a solvent into the vessel, and continue to stir evenly, thereby obtaining a glue solution. Dip fiberglass cloth (type being 2116, thickness being 0.08 mm) in the above mentioned glue solution, control the fiberglass cloth to get an appropriate thickness, and then dry the fiberglass cloth by heat to remove the solvent, thereby obtaining prepregs. Overlay a plurality of the prepared prepregs with each other, respectively clad a piece of copper foil to the two sides of the prepregs overlaid with each other, and then cure the prepregs in hot press at a curing temperature of 150-250 °C, a curing pressure of 25-60 kg/cm² and a curing time of 90 minutes, thereby obtaining a copper clad laminate.

### Embodiment 8:

Set a vessel, add 100 parts by weight of naphthol type novolac epoxy resin EXA-7318 (provided by Japanese DIC Co., Ltd., EEW being 250 g/eq) into the vessel, then add 90 parts by weight of HPC-8000-65T (provided by Japanese DIC Co., Ltd., solid content being 65%) as the active ester curing agent to stir evenly, then add 35 parts by weight of phosphinic aluminum salt (provided by Clariant company, phosphorus content being 23%) as the flame retardant, then add 0.075 parts by weight of DMAP as the curing accelerator, then add methylbenzene as a solvent into the vessel, and continue to stir evenly, thereby obtaining a glue solution. Dip fiberglass cloth (type being 2116, thickness being 0.08 mm) in the above mentioned glue solution, control the fiberglass cloth to get an appropriate thickness, and then dry the fiberglass cloth by heat to remove the solvent, thereby obtaining prepregs. Overlay a plurality of the prepared prepregs with each other, respectively clad a piece of copper foil to the two sides of the prepregs overlaid with each other, and then cure the prepregs in hot press at a curing temperature of 150-250 °C, a curing pressure of 25-60 kg/cm² and a curing time of 90 minutes, thereby obtaining a copper clad laminate.

### Comparison example 1:

Set a vessel, add 100 parts by weight of phenol novolac type epoxy resin N690 (provided by Japanese DIC Co., Ltd., EEW being 205 g/eq) into the vessel, then add 108.9 parts by weight of HPC-8000-65T (provided by Japanese DIC Co., Ltd., solid content being 65%) as the active ester curing agent to stir evenly, then add 30 parts by weight of phosphinic aluminum salt (provided by Clariant company, phosphorus content being 23%) as the flame retardant, then add 0.075 parts by weight of DMAP as the curing accelerator, then add methylbenzene as a solvent into the vessel, and continue to stir evenly, thereby obtaining a glue solution. Dip fiberglass cloth (type being 2116, thickness being 0.08 mm) in the above mentioned glue solution, control the fiberglass cloth to get an appropriate thickness, and then dry the fiberglass cloth by heat to remove the solvent, thereby obtaining prepregs. Overlay a plurality of the prepared prepregs with each other, respectively clad a piece of copper foil to the two sides of the prepregs overlaid with each other, and then cure the prepregs in hot press at a curing temperature of 150-250 °C, a curing pressure of 25-60 kg/cm² and a curing time of 90 minutes, thereby obtaining a copper clad laminate.

### Comparison example 2:

Set a vessel, add 50 parts by weight of phenol novolac type epoxy resin N690 (provided by Japanese DIC Co., Ltd., EEW being 205 g/eq) and 50 parts by weight of high-bromide epoxy resin BREN-105 (provided by Nippon Kayaku Co.,Ltd., bromine content being 35%) into the vessel, then add 96.9 parts by weight of HPC-8000-65T (provided by Japanese DIC Co., Ltd., solid content being 65%) as the active ester curing agent to stir evenly, then add 0.075 parts by weight of DMAP as the curing accelerator, then add methylbenzene as a solvent into the vessel, and continue to stir evenly, thereby obtaining a glue solution. Dip fiberglass cloth (type being 2116, thickness being 0.08 mm) in the above mentioned glue solution, control the fiberglass cloth to get an appropriate thickness, and then dry the fiberglass cloth by heat to remove the solvent, thereby obtaining prepregs. Overlay a plurality of the prepared prepregs with each other, respectively clad a piece of copper foil to the two sides of the prepregs overlaid with each other, and then cure the prepregs in hot press at a curing temperature of 150-250 °C, a curing pressure of 25-60 kg/cm² and a curing time of 90 minutes, thereby obtaining a copper clad laminate.

### Comparison example 3:

Set a vessel, add 100 parts by weight of biphenyl type novolac epoxy resin NC-3000H (provided by Nippon Kayaku Co.,Ltd., EEW being 288 g/eq) into the vessel, then add 36.5 parts by weight of TD-2090 (provided by Japanese DIC Co., Ltd., hydroxy equivalent being 105 g/eq) as the novolac curing agent to stir evenly, then add 30 parts by weight of phosphinic aluminum salt (provided by Clariant company, phosphorus content being 23%) as the flame retardant, then add 0.075 parts by weight of DMAP as the curing accelerator, then add methylbenzene as a solvent into the vessel, and continue to stir evenly, thereby obtaining a glue solution. Dip fiberglass cloth (type being 2116, thickness being 0.08 mm) in the above mentioned glue solution, control the fiberglass cloth to get an appropriate thickness, and then dry the fiberglass cloth by heat to remove the solvent, thereby obtaining prepregs. Overlay a plurality of the prepared prepregs with each other, respectively clad a piece of copper foil to the two sides of the prepregs overlaid with each other, and then cure the prepregs in hot press at a curing temperature of 150-250 °C, a curing pressure of 25-60 kg/cm² and a curing time of 90 minutes, thereby obtaining a copper clad laminate.

### Comparison example 4:

Set a vessel, add 100 parts by weight of biphenyl type novolac epoxy resin NC-3000H (provided by Nippon Kayaku Co.,Ltd., EEW being 288 g/eq) into the vessel, then add 77.5 parts by solid weight of HPC-8000-65T (provided by Japanese DIC Co., Ltd., solid content being 65%) as the active ester curing agent to stir evenly, then add 53.1 parts by weight of phosphate ester PX-200 (provided by DAIHACHI CHEMICAL INDUSTRY CO.,LTD., phosphorus content being 9%) as the flame retardant, then add 0.075 parts by weight of DMAP as the curing accelerator, then add methylbenzene as a solvent into the vessel, and continue to stir evenly, thereby obtaining a glue solution. Dip fiberglass cloth (type being 2116, thickness being 0.08 mm) in the above mentioned glue solution, control the fiberglass cloth to get an appropriate thickness, and then dry the fiberglass cloth by heat to remove the solvent, thereby obtaining prepregs. Overlay a plurality of the prepared prepregs with each other, respectively clad a piece of copper foil to the two sides of the prepregs overlaid with each other, and then cure the prepregs in hot press at a curing temperature of 150-250 °C, a curing pressure of 25-60 kg/cm² and a curing time of 90 minutes, thereby obtaining a copper clad laminate.

**Table 1. the physical property data of the embodiments and the comparison examples**

| performance index | Embodiment 1 | Embodiment 2 | Embodiment 3 | Embodiment 4 | Embodiment 5 | Embodiment 6 |
|---|---|---|---|---|---|---|
| Tg(DMA)/°C | 170 | 172 | 165 | 175 | 160 | 165 |
| Dk(5G) | 3.8 | 3.8 | 3.8 | 3.7 | 3.9 | 3.9 |
| Df(5G) | 0.0065 | 0.007 | 0.007 | 0.0085 | 0.0075 | 0.007 |
| hydroscopic property, % | 0.12 | 0.13 | 0.13 | 0.13 | 0.12 | 0.14 |
| resistance to humidity and heat | 3/3 | 3/3 | 3/3 | 3/3 | 3/3 | 2/3 |
| flame retardance | V-0 | V-0 | V-0 | V-0 | V-0 | V-0 |

**Table 2. the physical property data of the embodiments and the comparison examples (to continue)**

| performance index | Embodiment 7 | Embodiment 8 | Comparison example 1 | Comparison example 2 | Comparison example 3 | Comparison example 4 |
|---|---|---|---|---|---|---|
| Tg(DMA)/°C | 185 | 180 | 170 | 165 | 145 | 120 |
| Dk(5G) | 3.85 | 3.85 | 3.9 | 3.9 | 3.9 | 3.95 |
| Df(5G) | 0.0075 | 0.0075 | 0.013 | 0.0135 | 0.018 | 0.009 |
| hydroscopic property, % | 0.12 | 0.13 | 0.15 | 0.18 | 0.21 | 0.25 |
| resistance to humidity and heat | 3/3 | 3/3 | 3/3 | 3/3 | 3/3 | 1/3 |
| flame retardance | V-0 | V-0 | V-0 | V-0 | V-0 | V-0 |

As shown in the physical property data of Table 1 and Table 2, the comparison examples 1-2 adopt phenol novolac type epoxy resin and active ester to be cured, and comparing with the embodiments 1-8, the dielectric loss tangent is high; the epoxy resin with the same structure in the comparison example 3 adopts novolac to be cured with, but, the dielectric properties of the cured products are poor; phosphorus-containing flame retardant is adopted in the comparison example 4, but the cured products have low glass transition temperature, at the same time, for the hydroscopic property of the flame retardant itself is high, the cured products have comparatively poor resistance to humidity and heat.

In summary, comparing with an ordinary copper foil substrate, the copper clad laminate of the present invention has more excellent dielectric properties and higher glass transition temperature, at the same time, also has good resistance to humidity and heat, which is fit for the field of high frequency.

## Claims

1. An epoxy resin composition comprising: (A) epoxy resin containing two or more than two epoxy groups, (B) active ester curing agent and (C) phosphinic salt compound;
wherein the structural formula of component (A) is: 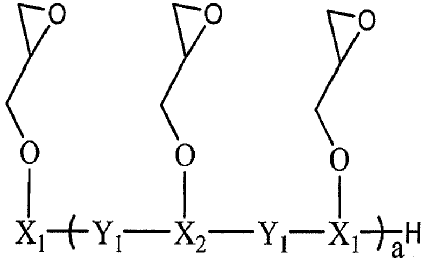
wherein X₁ and X₂ are identical or different and represent 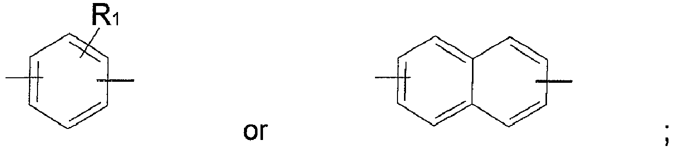
Y₁ represents -CH₂-, 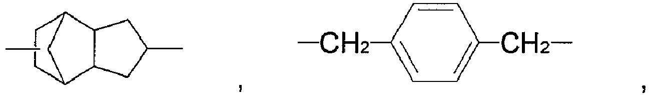 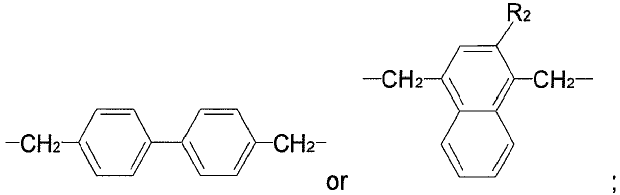
wherein R₁ represents hydrogen or an alkyl with the number of carbon atoms being 1-10; R₂ represents hydrogen or an alkyl with the number of carbon atoms being 1-10; and a represents an integer of 1-30;
wherein component (B) is obtained from the reaction of a phenol compound containing aliphatic hydrocarbon structure as connection structure, together with bifunctional carboxylic acid aromatic compound or acid halide and a monohydroxy compound; and
wherein component (C) is prepared by metal ion reacting with a phosphinic radical via substitution reaction and the structural formula of the phosphinic salt compound is: 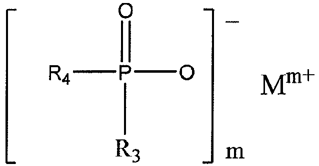 wherein m represents 2 or 3; R₃ and R₄ represent alkyl with the number of carbon atoms being 1-6 or aryl; M represents a metal atom selected from calcium, magnesium, aluminum, arsenic, zinc and iron.

2. The epoxy resin composition as claimed in claim 1, wherein taking the usage amount of component (A) as 100 parts by weight, the usage amount of component (B) is calculated according to the equivalent ratio of epoxy equivalent weight to active ester equivalent weight, and the equivalent ratio ranges from 0.85 to 1.2.

3. The epoxy resin composition as claimed in claim 1 or 2, wherein taking the total amount of component (A), component (B) and component (C) as 100 parts by weight, the usage amount of component (C) is 5-20 parts by weight.

4. The epoxy resin composition as claimed in any preceding claim, wherein component (B) is obtained from the reaction of a phenol compound containing aliphatic hydrocarbon structure as connection structure, together with bifunctional carboxylic acid aromatic compound or acid halide and a monohydroxy compound; wherein the usage amount of the bifunctional carboxylic acid aromatic compound or acid halide is 1 mol, the usage amount of the phenol compound containing aliphatic hydrocarbon structure as connection structure is 0.05-0.75 mol and the usage amount of the monohydroxy compound is 0.25-0.95 mol.

5. The epoxy resin composition as claimed in any preceding claim, wherein the structural formula of component (B) is: 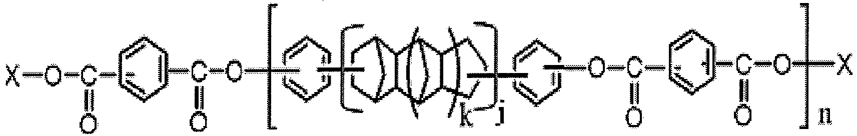 wherein X represents a benzene ring or naphthalene ring, j represents 0 or 1, k represents 0 or 1 and n ranges from 0.25 to 2.5.

6. The epoxy resin composition as claimed in any preceding claim further comprising curing accelerator and the curing accelerator is one or a mixture of more selected from the group consisting of imidazole compounds, derivatives of imidazole compounds, piperidine compounds, Lewis acids and triphenyl phosphine.

7. A prepreg obtained or obtainable from an epoxy resin composition as claimed in any preceding claim, wherein the prepreg comprises a reinforcing material, and the epoxy resin composition that adheres to the reinforcing material after the reinforcing material is dipped in the epoxy resin composition and then is dried.

8. A copper clad laminate obtained or obtainable from a prepreg as claimed in claim 7, wherein the copper clad laminate comprises a plurality of laminated prepregs and copper foil cladded to one side or two sides of the laminated prepregs.

## Patentansprüche

1. Epoxidharzzusammensetzung enthaltend: (A) Epoxidharz enthaltend zwei oder mehr als zwei Epoxidgruppen, (B) aktives Estervernetzungsmittel und (C) Phosphinsalzverbindung, wobei die Strukturformel der Komponente (A) ist: 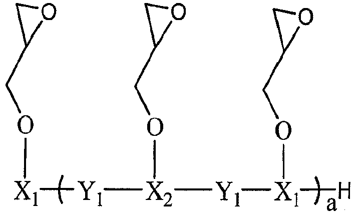
wobei X₁ und X₂ identisch oder unterschiedlich sind und darstellen 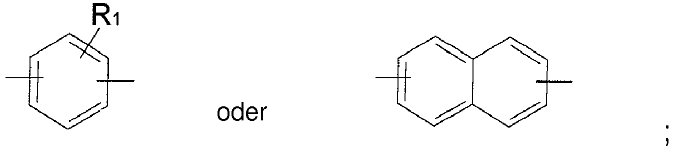
Y₁ ist -CH₂-, 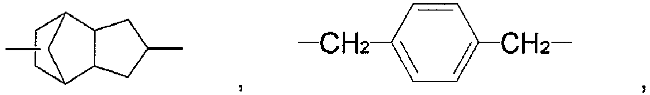 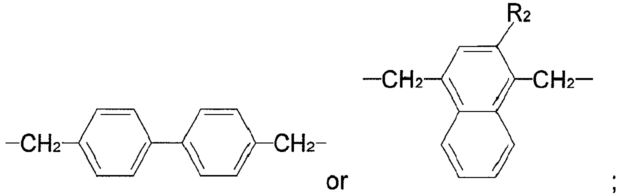
wobei R₁ Wasserstoff oder ein Alkyl mit einer Anzahl von Kohlenstoffatomen von 1-10 ist; R₂ Wasserstoff oder ein Alkyl mit einer Anzahl von Kohlenstoffatomen von 1-10 ist; und a eine ganze Zahl von 1-30 ist;
wobei Komponente (B) erhalten wird durch Reaktion einer Phenolverbindung enthaltend eine aliphatische Kohlenwasserstoffstruktur als Verbindungsstruktur zusammen mit einer bifunktionalen aromatischen Carbonsäureverbindung oder einem sauren Halogenid und einer Monohydroxyverbindung;
wobei die Komponente (C) hergestellt wird durch Reaktion eines Metallions mit einem Phosphinrest via einer Substitutionsreaktion und die Strukturformel der Phosphinsalzverbindung: 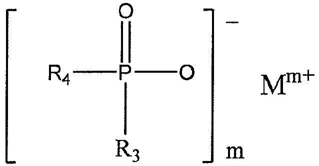 ist, wobei m 2 oder 3 ist; R₃ und R₄ Alkyl mit einer Anzahl an Kohlenstoffatomen von 1-6 oder Aryl sind; M ein Metallatom ausgewählt aus Kalzium, Magnesium, Aluminium, Arsen, Zink und Eisen ist.

2. Epoxidharzzusammensetzung nach Anspruch 1, wobei wenn die verwendete Menge an Komponente (A) als 100 Gewichtsteile genommen wird, die verwendete Menge an Komponente (B) nach dem Äquivalentverhältnis des Epoxidäquivalentgewichts zum Äquivalentgewicht des aktiven Esters berechnet wird und das Äquivalentverhältnis im Bereich von 0,85 bis 1,2 liegt.

3. Epoxidharzzusammensetzung nach Anspruch 1 oder 2, wobei falls die Gesamtmenge an Komponente (A), Komponente (B) und Komponente (C) als 100 Gewichtsteile genommen wird, die verwendete Menge an Komponente (C) 5-20 Gewichtsteile beträgt.

4. Epoxidharzzusammensetzung nach einem der vorhergehenden Ansprüche, wobei Komponente (B) erhalten wird durch Reaktion einer Phenolverbindung enthaltend eine aliphatische Kohlenwasserstoffstruktur als Verbindungsstruktur zusammen mit einer bifunktionalen aromatischen Carbonsäureverbindung oder einem sauren Halogenid und einer Monohydroxyverbindung; wobei die verwendete Menge der bifunktionalen aromatischen Carbonsäureverbindung oder des sauren Halogenids 1 mol ist, die verwendete Menge der Phenolverbindung enthaltend eine aliphatische Kohlenwasserstoffstruktur als Verbindungsstruktur 0,05-0,75 mol ist und die verwendete Menge der Monohydroxyverbindung 0,25-0,95 mol ist.

5. Epoxidharzzusammensetzung nach einem der vorhergehenden Ansprüche, wobei die Strukturformel der Komponente (B) ist: 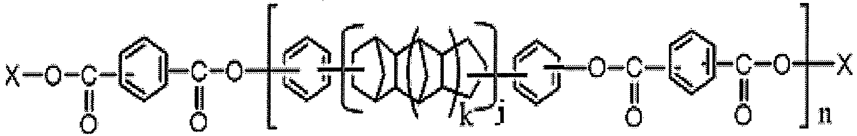 wobei X ein Benzolring oder ein Naphthalenring ist, j 0 oder 1 ist, k 0 oder 1 ist und n im Bereich von 0,25 bis 2,5 liegt.

6. Epoxidharzzusammensetzung nach einem der vorhergehenden Ansprüche ferner enthaltend einen Härtungsbeschleuniger, wobei der Härtungsbeschleuniger einer oder eine Mischung ausgewählt aus der Gruppe bestehend aus Imidazolverbindungen, Derivaten von Imidazolverbindungen, Piperidinverbindungen, Lewissäuren und Triphenylphosphin ist.

7. Prepreg hergestellt oder herstellbar aus einer Epoxidharzzusammensetzung nach einem der vorhergehenden Ansprüche, wobei das Prepreg ein Verstärkungsmaterial und die Epoxidharzzusammensetzung, welche an das Verstärkungsmaterial bindet nachdem das Verstärkungsmaterial in die Epoxidharzzusammensetzung eingetaucht und anschließend getrocknet worden ist, umfasst.

8. Kupferkaschiertes Laminat hergestellt oder herstellbar aus einem Prepreg nach Anspruch 7, wobei das kupferkaschierte Laminat eine Vielzahl von laminierten Prepregs und eine Kupferfolie mit der eine oder beide Seiten des laminierten Prepregs beschichtet ist, umfasst.

## Revendications

1. Composition de résine époxy comprenant : (A) une résine époxy contenant deux ou plus de deux groupes époxy, (B) un agent de durcissement de type ester actif et (C) un composé de sel phosphinique ;
dans laquelle la formule structurelle du composant (A) est : 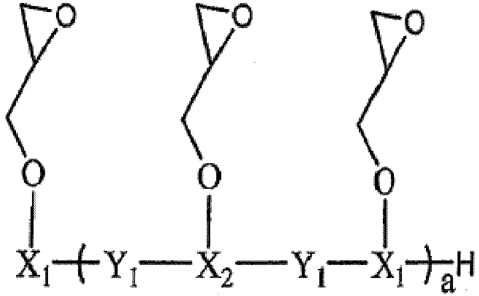
dans laquelle X₁ et X₂ sont identiques ou différents et représentent 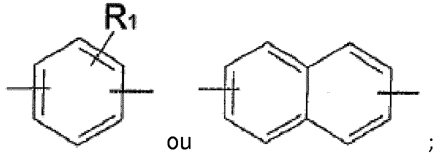
Y₁ représente -CH₂-, 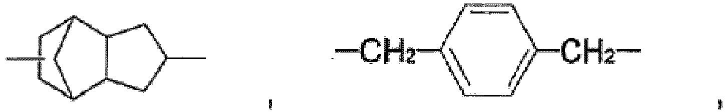 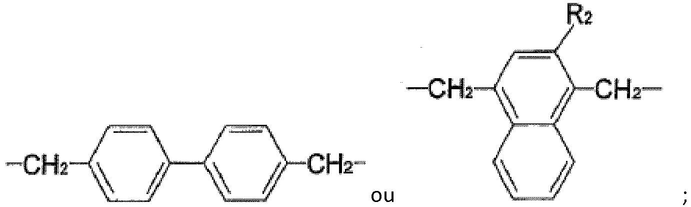
dans laquelle R₁ représente un hydrogène ou un alkyle ayant un nombre d'atomes de carbone allant de 1 à 10 ; R₂ représente un hydrogène ou un alkyle ayant un nombre d'atomes de carbone allant de 1 à 10 ; et a représente un nombre entier allant de 1 à 30 ;
dans laquelle le composant (B) est obtenu par la réaction d'un composé de phénol contenant une structure hydrocarbonée aliphatique en tant que structure de connexion, avec un composé aromatique d'acide carboxylique bifonctionnel ou un halogénure d'acide et un composé monohydroxylé ; et
dans laquelle le composant (C) est préparé par la réaction d'un ion métallique avec un radical phosphinique par l'intermédiaire d'une réaction de substitution et la formule structurelle du composé de sel phosphinique est : 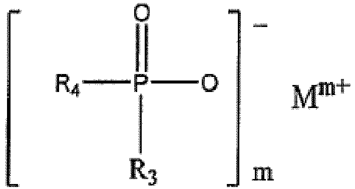 dans laquelle m représente 2 ou 3 ; R₃ et R₄ représentent un alkyle ayant un nombre d'atomes de carbone allant de 1 à 6 ou un aryle ; M représente un atome de métal sélectionné parmi le calcium, le magnésium, l'aluminium, l'arsenic, le zinc et le fer.

2. Composition de résine époxy selon la revendication 1, dans laquelle en prenant la quantité d'utilisation du composant (A) à 100 parties en poids, la quantité d'utilisation du composant (B) est calculée en fonction du rapport d'équivalents entre le poids équivalent d'époxy et le poids équivalent d'ester actif, et le rapport d'équivalents va de 0,85 à 1,2.

3. Composition de résine époxy selon la revendication 1 ou 2, dans laquelle en prenant la quantité totale du composant (A), du composant (B) et du composant (C) à 100 parties en poids, la quantité d'utilisation du composant (C) est de 5 à 20 parties en poids.

4. Composition de résine époxy selon une quelconque revendication précédente, dans laquelle le composant (B) est obtenu par la réaction d'un composé de phénol contenant une structure hydrocarbonée aliphatique en tant que structure de connexion, avec un composé aromatique d'acide carboxylique bifonctionnel ou un halogénure d'acide et un composé monohydroxylé ; dans laquelle la quantité d'utilisation du composé aromatique d'acide carboxylique bifonctionnel ou de l'halogénure d'acide est de 1 mole, la quantité d'utilisation du composé de phénol contenant une structure hydrocarbonée aliphatique en tant que structure de connexion est de 0,05 à 0,75 mole et la quantité d'utilisation du composé monohydroxylé est de 0,25 à 0,95 mole.

5. Composition de résine époxy selon une quelconque revendication précédente, dans laquelle la formule structurelle du composant (B) est : 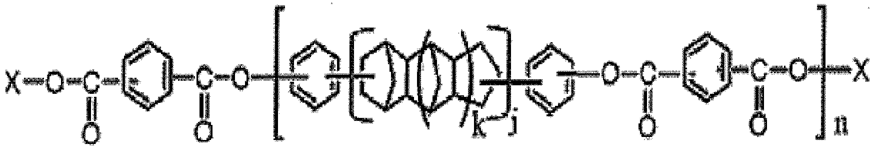 dans laquelle X représente un cycle benzène ou un cycle naphtalène, j représente 0 ou 1, k représente 0 ou 1 et n va de 0,25 à 2,5.

6. Composition de résine époxy selon une quelconque revendication précédente, comprenant en outre un accélérateur de durcissement et l'accélérateur de durcissement est un ou un mélange de plusieurs sélectionnés dans le groupe constitué des composés d'imidazole, des dérivés de composés d'imidazole, des composés de pipéridine, des acides de Lewis et de la triphénylphosphine.

7. Préimprégné obtenu ou pouvant être obtenu à partir d'une composition de résine époxy selon une quelconque revendication précédente, dans lequel le préimprégné comprend un matériau de renforcement, et la composition de résine époxy qui adhère au matériau de renforcement après que le matériau de renforcement est immergé dans la composition de résine époxy et ensuite est séché.

8. Stratifié recouvert de cuivre obtenu ou pouvant être obtenu à partir d'un préimprégné selon la revendication 7, dans lequel le stratifié recouvert de cuivre comprend une pluralité de préimprégnés stratifiés et une feuille de cuivre recouvrant une face ou les deux faces des préimprégnés stratifiés.
